# EUROPÄISCHE PATENTANMELDUNG

(11) **EP 2 390 921 A2**
(43) Veröffentlichungstag der Anmeldung: **30.11.2011**
(21) Anmeldenummer: 11168105.2
(22) Anmeldetag: 30.05.2011
(51) Int. Cl.: H01L 31/0216

(54) **Halbleitervorrichtung, insbesondere Solarzelle**

(30) Priorität: 31.05.2010 DE 102010017155
(71) Anmelder: Q-Cells SE, 06766 Bitterfeld-Wolfen (DE)
(72) Erfinder: Engelhart, Peter, 04157 Leipzig (DE); Seguin, Robert, 12109 Berlin (DE); Kessels, Wilhelmus Mathijs Marie, 5045 ZZ Tilburg (NL); Dingemans, Gijs, 5021 VX Tilburg (NL)
(74) Vertreter: Bakhtyari, Arash

(57) **Zusammenfassung**

Die Erfindung betrifft eine Halbleitervorrichtung, insbesondere eine Solarzelle, umfassend ein Halbleitersubstrat mit einer Halbleitersubstratoberfläche und eine Passivierung aus mindestens einer Passivierungsschicht, welche die Halbleitersubstratoberfläche oberflächenpassiviert, wobei die Passivierungsschicht eine Verbindung aus Aluminiumoxid, Aluminiumnitrid oder Aluminiumoxynitrid und zumindest einem weiteren Element umfasst.

## Beschreibung

Die Erfindung betrifft eine Halbleitervorrichtung, insbesondere eine Solarzelle.

Eine der begrenzenden Faktoren für die Effizienz von Halbleiterbauelementen und -vorrichtungen ist die Rekombination von Ladungsträgern an Halbleiteroberflächen, welche die Rekombinationsaktivität begünstigende Oberflächenzustände aufweisen. Dieses Problem ist insbesondere bei Solarzellen von Bedeutung. Denn in diesem Fall stehen die rekombinierten Ladungsträger nicht mehr für die Stromerzeugung zur Verfügung. Um Rekombinationen zu vermindern, muss die Halbleiteroberfläche passiviert werden, indem die Rekombinationsaktivität von Ladungsträgern über Oberflächenzustände herabgesetzt wird.

Für die Passivierung von Halbleiteroberflächen wird gegenwärtig vielfältig Aluminiumoxid eingesetzt (Al₂0₃ oder AlOₓ, wodurch ganz allgemein jede geeignete stöchiometrische Zusammensetzung von Aluminium und Sauerstoff gemeint ist). Aluminiumoxid weist eine hohe negative Flächenladungsdichte auf und kann, wenn mittelbar über eine Zwischenschicht oder unmittelbar auf die Halbleiteroberfläche aufgetragen, Ladungsträger von der Halbleiteroberfläche in das Halbleitervolumen verdrängen. Aufgrund dieser feldeffektpassivierenden Wirkung wird die Halbleiteroberfläche wirksam passiviert.

Derartige Passivierschichten aus Aluminiumoxid haben jedoch den Nachteil, dass sie gegenüber bestimmten Herstellungsprozessen, insbesondere bei der Herstellung von Solarzellen, nicht beständig sind, beispielsweise gegenüber nasschemischen Reinigungs- oder Ätzprozessen. Sie müssen daher mittels zusätzlicher Deckschichten geschützt werden. Dies führt zu höheren Produktionskosten und längeren Produktionszeiten.

Darüber hinaus muss insbesondere bei Solarzellen nicht nur auf die elektrischen Eigenschaften der Schichtfolgen geachtet werden, sondern auch die optischen Eigenschaften der einzelnen Schichten müssen aufeinander abgestimmt sein. Wird als Material der Passivierungsschicht jedoch lediglich Aluminiumoxid verwendet, so ist man im Design der Solarzelle auf einen bestimmten Brechungsindex (nämlich etwa 1,6) festgelegt.

Es ist daher Aufgabe der Erfindung, eine Halbleitervorrichtung, insbesondere eine Solarzelle, bereitzustellen, welche mit geringerem Kosten- und Zeitaufwand herstellbar ist und eine effektive und zugleich gegenüber Herstellungsprozessschritten beständige Passivierung aufweist.

Die Aufgabe wird erfindungsgemäß durch eine Halbleitervorrichtung mit den Merkmalen des Anspruchs 1 gelöst. Vorteilhafte Weiterbildungen der Erfindung sind in den Unteransprüchen aufgeführt.

Bei der Halbleitervorrichtung handelt es sich vorzugsweise um eine Solarzelle, bei der eine verbesserte Oberflächenpassivierung der
Halbleitersubstratoberfläche zu einer effizienteren Umwandlung von einfallendem Licht in elektrischen Strom führt. Eine gute
Oberflächenpassivierung kann jedoch auch in anderen Bereichen der Halbleitertechnik von Bedeutung sein. Die hier beschriebene Oberflächenpassivierung kann bei Solarzellen vorderseitig, also auf der Lichteinfallseite der Solarzelle, rückseitig, also auf der Licht abgewandten Seite der Solarzelle, oder beidseitig angewendet sein. Vorteilhafterweise ist das Halbleitersubstrat aus Silizium gebildet. Das Halbleitersubstrat kann einen Halbleiterwafer umfassen.

Die Erfindung beruht auf der Erkenntnis, dass mittels Hinzufügen von zusätzlichen Elementen zu einer Aluminiumoxidverbindung einer Passivierungsschicht dessen chemische, elektrische und / oder optische Eigenschaften optimiert werden können. Dies gilt sowohl im Hinblick auf die Oberflächenpassivierung als auch im Hinblick auf weitere funktionelle Aufgaben, welche die Passivierungsschicht auf der Halbleitervorrichtung während und / oder nach ihrer Herstellung wahrnehmen kann.

Hierzu wird als Material für die Passivierungsschicht eine Verbindung verwendet, welche Aluminiumoxid, Aluminiumnitrid oder Aluminiumoxynitrid und zumindest ein weiteres Element enthält, welches nicht Aluminium ist. Die chemische Formel für ein derartiges Material kann allgemein als AlₓM_{y}O_{z}, AlₓM_{y}N_{z} oder Al_{X}MₘO_{y}N_{z} notiert werden, wobei ein gewünschtes stöchiometrisches Verhältnis durch geeignete Wahl von x, y, z und gegebenenfalls m erzielt wird. Hier steht M für das weitere Element. Im letzten Fall, AlₓMₘO_{y}N_{z}, wenn M für ein weiteres Metallelement steht, kann beispielsweise durch geeignete Wahl des stöchiometrisches Verhältnisses der Brechungsindex des Materials eingestellt werden, und zwar von etwa 1,6 bei z=0 bis zu etwa 2,0 bei y=0.

Mittels Hinzufügen des weiteren Elements kann also der Brechungsindex der Passivierungsschicht verändert werden, um die Passivierung auf der Halbleitervorrichtung zusätzlich für optische Funktionen einsetzen zu können, insbesondere durch gezielte Beeinflussung ihres Reflexions- und / oder Absorptionsverhaltens. Die vorliegend genannten Brechungsindexwerte beziehen sich auf Messungen im sichtbaren Lichtspektrum.

Es ist darauf hinzuweisen, dass es sich beim weiteren Element um einen Verbindungspartner zu Aluminiumoxid, Aluminiumnitrid oder Aluminiumoxynitrid nur dann handeln kann, wenn das weitere Element stöchiometrisch signifikant in der Passivierungsschicht enthalten ist. Es handelt sich hierbei also nicht um natürliche Verunreinigungen mit dem weiteren Element, die beim Herstellungsprozess zwangsläufig auftreten. Sinnvollerweise beträgt die Dichte des weiteren Elements in dem Material der Passivierungsschicht mindestens 1 Atomprozent (at%). Vorzugsweise weist das weitere Element in dem Material der Passivierungsschicht eine Dichte von mindesten etwa 2 at%, 5 at%, 8 at%, 10 at%, 15 at% oder 20 at% auf.

Bei einer bevorzugten Ausführungsform ist vorgesehen, dass die Verbindung der Passivierungsschicht als ein weiteres Element Stickstoff, Kohlenstoff, Phosphor, Bor und / oder Fluor umfasst. Bei Zugabe von Stickstoff oder Verwendung von Aluminiumoxynitrid (AlₓO_{y}N_{z}) für die Herstellung der Passivierungsschicht ist möglicherweise eine höhere Stabilität zu erwarten, insbesondere chemische Stabilität. Dieser Effekt ist beim Hinzufügen von Stickstoff zu Siliziumoxidschichten bereits bekannt.

Während durch Hinzugeben von Stickstoff der Brechungsindex der Passivierungsschicht erhöht wird, wird er mittels Zugabe von Fluor vermindert. Aluminiumfluorid hat beispielsweise einen Brechungsindex von etwa 1,4. Mittels Dotierung durch Bor oder Phosphor kann zudem die chemische Beständigkeit der Passivierungsschicht erhöht werden. Darüber hinaus kann eine so dotierte Passivierungsschicht als Quelle für selektives Dotieren einer darunterliegenden Halbleiterschicht dienen, beispielsweise mittels Laserdotierung.

Mittels Einbau von Kohlenstoff in das Aluminiumoxid können weitere Eigenschaften der Passivierungsschicht beeinflusst werden. Die Kohlenstoff-Konzentration kann beispielsweise mittels Einstellung der Halbleitersubstrat-Temperatur während einer Abscheidung der Passivierungsschicht gezielt manipuliert werden. Eine geringere Temperatur führt zu einer höheren Kohlenstoff-Konzentration in der Passivierungsschicht. Die Kohlenstoff-Konzentration in der Passivierungsschicht kann alternativ oder kumulativ mittels Nutzung eines Kohlendioxid-Plasmas beeinflussen werden.

In einer vorteilhaften Weiterbildung ist vorgesehen, dass die Verbindung der Passivierungsschicht als ein weiteres Element ein Metall umfasst. Insbesondere ist in einer zweckmäßigen Ausgestaltung vorgesehen, dass die Verbindung der Passivierungsschicht als ein weiteres Element ein Metall der seltenen Erden umfasst.

Beispielsweise kann mittels Beimischung einer geeigneten Menge optisch aktiver Elemente wie zum Beispiel Erbiumionen (Er3+) der Effekt der Aufwärtskonvertierung (Up-Conversion) verwendet werden. Hierbei wird aus zwei langwelligen Photonen, die nicht von der Solarzelle absorbiert werden können, ein kurzwelliges generiert, welches dann zur Stromgewinnung durch Absorption im Halbleiter zur Verfügung steht. Allgemein kann mittels Beimischen von Erbium, Ytterbium oder Terbium in Form von Atomen oder Ionen die spektrale Konversion (up-conversion, down-conversion oder shift) verbessert und gleichzeitig eine hohe Oberflächenpassivierung der Halbleitersubstratoberfläche garantiert werden.

Es gibt zudem Hinweise darauf, dass durch den Einbau einer geringen Menge von Erbium in Aluminiumoxid die Kristallisationstemperatur erhöht wird. Es wird davon ausgegangen, dass sich dieser Effekt auch für andere Elemente zeigt. Generell kann hieraus aufgrund der Kristallisation eine erhöhte thermische Stabilität hergeleitet werden. Dies ist insbesondere bei der Metallisierung von Solarzellen von Bedeutung, wenn die Solarzelle hierbei einer Wärmebehandlung ausgesetzt wird, auch Feuerschritt genannt.

Bevorzugterweise ist vorgesehen, dass die Passivierungsschicht unmittelbar auf der Halbleitersubstratoberfläche angeordnet ist. Mit anderen Worten, es befindet sich in dieser Ausführungsform keine weitere Schicht zwischen Passivierungsschicht und Halbleitersubstratoberfläche. Die Halbleitersubstratoberfläche kann in allen hier beschriebenen Ausführungsformen unterschiedlich dotierte Bereiche aufweisen, beispielsweise um Basis- und Emitterbereiche in dem Halbleitersubstrat auszubilden.

Bei einer zweckmäßigen Ausführungsform ist vorgesehen, dass die Passivierung eine oder mehrere weitere zwischen der Passivierungsschicht und der Halbleitersubstratoberfläche angeordnete Passivierungsschichten umfasst. Beispielsweise kann eine chemisch passivierende weitere Passivierungsschicht unmittelbar auf die Halbleitersubstratoberfläche aufgebracht sein. Diese weitere Passivierungsschicht kann mittels Oxidation der Halbleitersubstratoberfläche oder vorteilhafterweise mittels eines Abscheideprozesses erzeugt sein.

In einer vorteilhaften Ausgestaltung ist vorgesehen, dass die Passivierung zumindest eine weitere Passivierungsschicht umfasst, welche auf einer der Halbleitersubstratoberfläche abgewandten Seite der Passivierungsschicht angeordnet ist.

Gemäß einer bevorzugten Weiterbildung ist vorgesehen, dass die Passivierung eine alternierende Schichtfolge aus der Passivierungsschicht und einer weiteren Passivierungsschicht umfasst. Die Schichtfolge umfasst hierbei vorzugsweise zwischen 2 und 1000 Passivierungsschichten, bevorzugt mindestens 10 oder mindestens 100 Passivierungsschichten. Beispiele hierfür bilden eine Schichtfolge aus Titanoxid und Aluminiumoxid (TiO₂/AlOₓ/TiO₂/AlOₓ/TiO₂/AlOₓ ...) oder eine Schichtfolge aus Siliziumoxid und Aluminiumoxid (SiO₂/AlOₓ/SiO₂/AlOₓ/SiO₂/AlOₓ ...). Bevorzugt handelt es sich bei jeder der Passivierungsschichten, aus denen die Passivierung gebildet ist, um eine Monolage aus dem jeweiligen Material, wobei auch eine größere Anzahl an Monolagen pro Passivierungsschicht möglich sind, beispielsweise 5, 10 oder mehr Monolagen.

Da die einzelne Teilschichten / Monolagen andere physikalische, optische und / oder elektrische Eigenschaften als das Grundmaterial (bulk material) aufweisen können, verhält sich ein derartiger Mehrschichtstapel nicht wie ein Schichtstapel aus zwei Grundmaterialien. Des Weiteren ändert sich die optische Eigenschaft des Mehrschichtsystems mit sehr dünnen Einzelschichten. So ist beispielsweise bekannt, dass mit alternierenden Schichten aus Aluminiumoxid und Titanoxid ein sogenanntes Nano-Laminat hergestellt werden kann, bei dem über das Schichtdickenverhältnis zwischen den beiden Teilschichten der Gesamt- oder globale Brechungsindex des Laminats stufenlos zwischen 1,6 (Brechungsindex von Aluminiumoxid) und 2,4 (Brechungsindex von Titandioxid) eingestellt werden kann.

Um die hier beschriebenen Passivierungsschichten mittels Abscheidevorgängen herzustellen, können die unterschiedlichen Elemente während der Abscheidung zu den Ausgangsstoffen hinzugefügt werden. Für die Abscheidung eignen sich sowohl chemische als auch physikalische Abscheideverfahren aus der Gasphase, welche bevorzugt durch ein Plasma unterstützt ablaufen können. Es sind auch nasschemische Abscheideverfahren einsetzbar.

Vorteilhafterweise ist vorgesehen, dass die Passivierungsschicht eine atomlagenabgeschiedene Schicht ist. Anders ausgedrückt, wird die Passivierungsschicht bei der Herstellung mittels Atomlagenabscheidung (atomic layer deposition - ALD) aufgebracht, die gegebenenfalls durch ein Plasma unterstützt ist. Hierbei kann der Einbau weiterer Elemente gezielt vorgenommen werden, indem diese Elemente zyklusweise zu den Ausgangsstoffen oder Plasmagasen im Abscheidereaktor geleitet werden. Die zyklische Abscheidung erlaubt zudem eine graduelle Änderung von Schichteigenschaften wie beispielsweise Brechungsindex senkrecht zur Schichtfläche. Dies ist vorteilhaft beispielsweise für eine optische Anpassung auf der Lichteinfallseite einer Solarzelle. Außerdem kann mittels einer graduellen Veränderung von Prozessparametern die Prozessgeschwindigkeit optimiert werden, da sich die Dichte der Passivierungsschicht hierbei ändern kann, was die Abscheiderate beeinflusst.

Gemäß einer bevorzugten Ausgestaltung ist vorgesehen, dass die Passivierungsschicht als Antireflexionsschicht, als Reflexionsschicht oder als Teil einer derartigen Schicht ausgelegt ist. Die Passivierungsschicht kann auch andere Funktionen übernehmen, insbesondere auch Funktionen während der Herstellung der Halbleitervorrichtung. Sie kann beispielsweise als Ätz-, Textur-und / oder Diffusionsbarriere wirken.

Im Folgenden wird als Ausführungsbeispiel das Ergebnis eines
Abscheideprozesses einer Passivierungsschicht aus Aluminiumoxynitrid (AlₓO_{y}N_{z}) beschrieben. Es wurde ein Plasma unterstütztes Atomlagenabscheideverfahren eingesetzt, mit einer Plasmaleistung von etwa 150 W und einem Kammerdruck von etwa 170 mTorr, wobei das Substrat auf eine Temperatur von 200°C gehalten wurde. Als Aluminium-Präkursor wurde Trimethylaluminium (TMA) mit einer Dosiszeit von 20 ms verwendet. In die Reaktionskammer wurde Argon mit einem Gasmengenstrom von 20 Standardkubikzentimeter pro Minute (sccm) eingeleitet. Die Abscheidezeit war 3,5 Sekunden. Bei diesen Parametern wurden drei Abscheidevorgänge mit jeweils unterschiedlichen Gaskonzentrationen für Stickstoff (N₂) und Sauerstoff (O₂) durchgeführt, wodurch die so gebildeten Schichten unterschiedliche Brechungsindizes und Wachstumsraten aufweisen.

Bei Gasmengenströmen von 10 sccm für N₂ und 40 sccm für O₂ entstand eine Aluminiumoxynitridschicht bei einer Wachstumsrate von etwa GPC=0,36 nm (GPC: growth per cycle, Schichtwachstum pro Zyklus) mit einem Brechungsindex von etwa n=1,57.

Bei Gasmengenströmen von 25 sccm für N₂ und 25 sccm für O₂ entstand eine Aluminiumoxynitridschicht bei einer Wachstumsrate von etwa GPC=0,33nm mit einem Brechungsindex von etwa n=1,59.

Bei Gasmengenströmen von 40 sccm für N₂ und 10 sccm für O₂ entstand eine Aluminiumoxynitridschicht bei einer Wachstumsrate von etwa GPC=0,29nm mit einem Brechungsindex von etwa n=1,63.

Ohne Zugabe von Sauerstoff gebildete Schichten hatten lediglich eine Wachstumsrate von etwa GPC=0,06nm.

## Patentansprüche

1. Halbleitervorrichtung, insbesondere Solarzelle, umfassend ein Halbleitersubstrat mit einer Halbleitersubstratoberfläche und eine Passivierung aus mindestens einer Passivierungsschicht, welche die Halbleitersubstratoberfläche oberflächenpassiviert, wobei die Passivierungsschicht eine Verbindung aus Aluminiumoxid, Aluminiumnitrid oder Aluminiumoxynitrid und zumindest einem weiteren Element umfasst.

2. Halbleitervorrichtung nach Anspruch 1, **dadurch gekennzeichnet, dass** die Verbindung der Passivierungsschicht als ein weiteres Element Stickstoff, Kohlenstoff, Phosphor, Bor und / oder Fluor umfasst.

3. Halbleitervorrichtung nach Anspruch 1 oder 2, **dadurch gekennzeichnet, dass** die Verbindung der Passivierungsschicht als ein weiteres Element ein Metall umfasst.

4. Halbleitervorrichtung nach Anspruch 3, **dadurch gekennzeichnet, dass** die Verbindung der Passivierungsschicht als ein weiteres Element ein Metall der seltenen Erden umfasst.

5. Halbleitervorrichtung nach einem der vorangehenden Ansprüche, **dadurch gekennzeichnet, dass** die Passivierungsschicht unmittelbar auf der Halbleitersubstratoberfläche angeordnet ist.

6. Halbleitervorrichtung nach einem der Ansprüche 1 bis 4, **dadurch gekennzeichnet, dass** die Passivierung eine oder mehrere weitere zwischen der Passivierungsschicht und der Halbleitersubstratoberfläche angeordnete Passivierungsschichten umfass.

7. Halbleitervorrichtung nach einem der vorangehenden Ansprüche, **dadurch gekennzeichnet, dass** die Passivierung zumindest eine weitere Passivierungsschicht umfasst, welche auf einer der
Halbleitersubstratoberfläche abgewandten Seite der Passivierungsschicht angeordnet ist.

8. Halbleitervorrichtung nach Anspruch 7, **dadurch gekennzeichnet, dass** die Passivierung eine alternierende Schichtfolge aus der Passivierungsschicht und einer weiteren Passivierungsschicht umfasst.

9. Halbleitervorrichtung nach einem der vorangehenden Ansprüche, **dadurch gekennzeichnet, dass** die Passivierungsschicht eine atomlagenabgeschiedene Schicht ist.

10. Halbleitervorrichtung nach einem der vorangehenden Ansprüche, **dadurch gekennzeichnet, dass** die Passivierungsschicht als Antireflexionsschicht, als Reflexionsschicht oder als Teil einer derartigen Schicht ausgelegt ist.
